(19) **Europäisches Patentamt**

**European Patent Office**

**Office européen des brevets**

(11) **EP 1 225 705 A2**

(12) **EUROPEAN PATENT APPLICATION**

(43) Date of publication:
**24.07.2002 Bulletin 2002/30**

(51) Int Cl.$^7$: **H03M 13/29**

(21) Application number: **01310572.1**

(22) Date of filing: **18.12.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **22.12.2000 GB 0031501**

(71) Applicant: **Tandberg Television ASA
1326 Lysaker (NO)**

(72) Inventors:
• **Huggett, Anthony Richard
   Hampshire SO50 5PZ (GB)**

• **Markarian, Garegin
   Hampshire SO16 7HN (GB)**
• **Pickavance, Keith
   Hampshire SO51 7RW (GB)**

(74) Representative: **Molyneaux, Martyn William
   Wildman, Harrold, Allen & Dixon
   11th Floor, Tower 3,
   Clements Inn,
   London WC2A 2AZ (GB)**

(54) **Method and apparatus for encoding a product code**

(57)    An apparatus for producing a product code having a first dimension systematic block code of length $n_x$ elements and a second dimension systematic block code of length $n_y$ elements has a first dimension encoder 12 for receiving a data element stream 11 to produce the first dimension block code having $k_x$ data elements and $n_x$-$k_x$ parity elements, the parity elements being derived from the data elements. The first dimension encoder is arranged to produce $k_y$ first dimension code vectors where $k_y$ is the data element length of the second dimension systematic block code. The second dimension encoder 14-16 is representative of $n_x$ encoders. The second dimension encoder receives the first dimension code vectors as they are produced and derives ($n_x n_y$-$n_x k_y$) parity elements for the second dimension systematic block code. The second encoder is arranged to output the second dimension code vectors as each is produced so as to thereby produce the encoded product code

Fig.1.

EP 1 225 705 A2

# Fig.1.cont.

Read out matrix row by row

3

| $d_0$ | $d_1$ | | $d_{kx-1}$ | $p_0$ | $p_1$ | ... | $p_{nx-kx-1}$ |
|---|---|---|---|---|---|---|---|

| $d_k$ | ... | $d_{2kx-1}$ | $p_{nx-kx}$ | ... | $d_{kykx-1}$ | $p_{(ky-1)(nx-kx)}$ | ... |
|---|---|---|---|---|---|---|---|

| $p_{ky(nx-kx)-1}$ | $p_{ky(nx-kx)}$ | $p_{ky(nx-kx)+1}$ | $p_{ky(nx-kx)+2}$ | ... | $p_{ky(nx-kx)+nx-1}$ | $p_{ky(nx-kx)+nx}$ | ... | $p_{nynx-kykx-1}$ |
|---|---|---|---|---|---|---|---|---|

**Description**

This invention relates to a method of encoding a product code and an apparatus therefor.

It is known that on communication channels, errors occur randomly and in bursts. Random error correcting codes or single burst error correcting codes are either inefficient or inadequate and it is, therefore, desired to produce codes which are capable of correcting random errors and/or single or multiple bursts.

A known technique is to use an interleaver with a so-called product code which is formed by, for example, a two-dimensional code $C_xC_y$, where $C_x$ is a linear code of overall length $n_x$ bits formed of $k_x$ data bits and having $n_x-k_x$ parity bits. The other linear code $C_y$ has overall length $n_y$ bits and is formed of $k_y$ data bits and $n_y-k_y$ parity bits. The linear code $C_xC_y$ is formed such that each code vector is a rectangular array of $n_x$ columns and $n_y$ rows in which every row is a code vector in $C_x$ and every column is a code vector in $C_y$. Such a two-dimensional code is called a direct product of $C_x$ and $C_y$. A three-dimensional code may be additionally formed having linear code bits $C_z$, comprising $k_z$ data bits, $n_z-k_z$ parity bits and overall length $n_z$ bits. Such codes are described in "Error Control Coding: Fundamentals and Applications" by Lin and Costello, published by Prentice Hall Inc. at page 274. The same work also describes encoding of cyclic codes at page 95 thereof.

Turbo codes are also known in which two encoders generate parity symbols from two recursive convolutional codes, each with a small number of states. The data bits are typically transmitted uncoded. An interleaver permutes the original data bits before being applied to a second encoder. The permutation allows that input sequences, for which one encoder produces low weight code words, will usually cause the other encoder to produce high weight code words. Thus, even though the constituent codes are individually weak, the combination is extremely powerful.

Turbo codes and turbo product codes allow good performance to be achieved by the employment of an iterative decoding algorithm using simple decoders which are individually matched to the constituent codes. Each constituent decoder sends a posteriori likelihood estimates of the decoded bits to another decoder and uses the corresponding estimates from another decoder as a priori likelihoods. The noisy encoded information bits from the channel are available to each decoder to initialise the a priori likelihoods. The turbo (product) decoder iterates between the outputs of the constituent decoders for a number of iterations, such that the final decoded output is a hard quantized version of the likelihood outputs of one of the decoders.

A two-dimensional product code, which may be a turbo product code, is constructed by arranging an incoming data stream into a rectangular matrix of size $k_x$ columns by $k_y$ rows. Parity bits from a systematic code are calculated from each row of data to provide an array of size $n_x$ by $k_y$. Parity bits are then calculated from each column of the horizontal encoded array to give a turbo product code encoded array of size $n_x$ by $n_y$. The element encoded bits are then read out and passed to a channel for transmission. In a three-dimensional array, the array would be of size $n_xn_yn_z$.

A known turbo product code encoder is made by A.H.A. Inc. under type number 4501 IC, which comprises a processing core connected to RAM. Data arriving at the input of the encoder is stored in a memory. Once all the data bits for a block are present, encoding of the block commences. Parity bits are calculated by the encoder core. Only when all the parity bits have been calculated and the block is complete may the values be read out. The overall latency of such a design for a code with $n_x=n_y=64$ and $k_x=k_y=57$ is 5,678 clock cycles. Thus, the latency, i.e. the number of clock cycles between applying data and reading out encoded data is lengthy. It may be considered that shortening the code would reduce the latency, but shortening the code is extremely difficult with the known architecture. If it is desired to shorten either the horizontal (x) and/or vertical (y) codes, it is necessary to insert zeros into the input stream to pad out the data array and then to remove the zeros from the encoded stream before passing the data to the transmission channel.

Additionally, because of the complexity of the decoder at a receiver, the systematic codes from which the turbo product code parity bits are generated are restricted to very simple extended Hamming codes.

The present invention seeks to provide a method of encoding a product code, which may be a turbo product code, which may be constructed from any convenient systematic block code in which the systematic bits occur in order, i.e. using not only Hamming codes, but also other types of systematic block codes. These might be other binary block codes, for example, low density parity check codes, but as will be understood by those skilled in the art, it is possible to construct product codes based on codes which are based upon higher order Galois Fields instead of Hamming codes which are based on GF(2). So as to produce Hamming codes, exclusive OR gates in an encoder perform addition modulo 2. Such a function is referred to by mathematicians as GF(2) arithmetic. Codes exist which operate by taking as the sum modulo some other power of 2, e.g. 4, 8, 256. Such codes operate on individual data elements which are larger than a single binary digit, e.g. the (255, 239) Reed - Solomon Code which operates on bytes and corrects 8 or less erroneous bytes out of 255 (regardless of the number of bits in error in each erroneous byte). The encoder for such a code takes 239 bytes and appends 16 parity bytes using a similar, but more complex, structure than the Hamming encoder. The present invention is also applicable to such encoders.

According to a first aspect of this invention there is provided a method of encoding a product code having a first dimension systematic block code of length $n_x$ elements and a second dimension systematic block code of length $n_y$ elements including the steps of:

(a) applying a data element stream to first dimension encoder means to produce said first dimension systematic block code having $k_x$ data elements and $n_x$-$k_x$ parity elements, where said parity elements are derived from said $k_x$ data elements,

(b) repeatedly applying said data element stream to said first dimension encoder means to produce $k_y$ first dimension code vectors, where $k_y$ is the data element length of the second dimension systematic block code,

(c) as each one of said $k_y$ first dimension code vectors is produced, outputting said first dimension code vectors to second dimension encoder means representative of $n_x$ encoders,

(d) deriving ($n_x n_y$-$n_x k_y$) parity elements for said second dimension systematic block code vectors, and

(e) outputting second dimension code vectors as each is produced so as to provide said encoded product code.

Preferably, said product code is a turbo product code.

In an embodiment, said second dimension encoder means comprises $n_x$ encoders each producing a total of $n_y$ second dimension encoded elements from $k_y$ input data elements or first dimension parity elements.

Because such an embodiment requires a large number of encoders, in a preferred embodiment, said first dimension systematic block code is applied in sequence to said second dimension encoder means and said second dimension encoder means includes a parity generator having a random access memory (RAM) associated therewith thereby repeatedly clocking data and parity elements in to an out of said RAM to synthesize said $n_x$ encoders.

Preferably, said systematic block code is a Hamming code and, advantageously, an extended Hamming code. In such an embodiment, said data element is a single binary bit but, in an alternative embodiment, said data element has a length of two or more binary digits.

Advantageously, said first dimension encoder means includes a Hamming parity generator provided to produce said parity elements of said first dimension systematic block code and, preferably, also includes an extended Hamming parity generator adapted to receive output from said Hamming parity generator to produce an extended Hamming parity element for said first dimension systematic block code.

Conveniently, said second dimension encoder means includes a further Hamming parity generator connected to receive output from said extended Hamming parity generator so as to produce said parity elements of said second dimension systematic block code and, preferably, said second dimension encoder means also includes a further extended Hamming parity generator adapted to receive output from said further Hamming parity generator so as to produce said encoded product code.

Advantageously, the output counter value of a first dimension counter having a range 0 to $n_x$.1 is applied to control signal generator means which supplies a clocking signal to a second dimension counter having a range 0 to $n_y$-1, and said control signal generator means applies control signals to said first and second dimension encoder means according to the output values of both of the aforesaid counters.

According to a second aspect of this invention there is provided an apparatus for producing a product code having a first dimension systematic block code of length $n_x$ elements and a second dimension systematic block code of length $n_y$ elements, said apparatus including first dimension encoder means for receiving a data element stream to produce therefrom said first dimension systematic block code having $k_x$ data elements and $n_x$-$k_x$ parity elements, where said parity elements are derived from said $k_x$ data elements, said first dimension encoder means being arranged to produce $k_y$ first dimension code vectors, where $k_y$ is the data element length of the second dimension systematic block code, and second dimension encoder means representative of $n_x$ encoders, said second dimension encoder means being arranged to receive said first dimension code vectors as they are produced and deriving ($n_x n_y$-$n_x k_y$) parity elements for said second dimension systematic block code, whereby said second encoder means is arranged to output second dimension code vectors as each is produced so as to produce said encoded product code.

Preferably, said product code is a turbo product code.

In an embodiment, said second dimension encoder means comprises $n_x$ encoders each producing a total of $n_y$ second dimension encoded elements from $k_y$ input data elements or first dimension parity elements.

In a preferred embodiment, said second dimension encoder means includes a parity generator having a RAM associated therewith, whereby said first dimension systematic block code is applied in sequence to said parity generator and control signal generator means are provided for repeatedly clocking data and parity elements in to and out of said RAM so that $n_x$ encoders are thereby synthesized.

Preferably, said systematic block code is a Hamming code and, advantageously, an extended Hamming code. In such an embodiment, said data element is a single binary digit but, in an alternative embodiment, said data element has a length of two or more binary digits.

Advantageously, said first dimension encoder means includes a Hamming parity generator provided to produce said parity elements of said first dimension systematic block code and, preferably, said first dimension encoder also includes an extended Hamming parity generator adapted to receive output from said Hamming parity generator so as to produce an extended Hamming parity element for said first dimension systematic block code.

Conveniently, said second dimension encoder means includes a further Hamming parity generator connected to receive output from said extended Hamming parity generator for producing said parity elements of said second dimension systematic block code and, preferably, said second dimension encoder also includes a further extended Hamming parity generator adapted to receive output from said further Hamming generator so as to produce said encoded product code.

Advantageously, the output counter value of a first dimension counter having a range 0 to $n_x$_1 is applied to control signal generator means which supplies a clocking signal to a second dimension counter having a range 0 to $n_y$-1, and said control signal generator means applies control signals to said first and second dimension encoder means according to the output values of both of the aforesaid counters.

The invention will now be described, by way of example, with reference to the accompanying drawings, in which:

Figure 1 shows, in schematic form, a manner of operation of the present invention utilising a two-dimensional encoded array,

Figure 2 shows an apparatus for producing a two-dimensional turbo product code in accordance with this invention,

Figure 3 shows, in block schematic form, a Hamming parity generator used in an embodiment of this invention,

Figure 4 shows, in block schematic form, a Hamming generator for generating an extended parity bit,

Figure 5 shows, in block schematic form, a preferred embodiment of an apparatus in accordance with this invention, and

Figure 6 shows, in schematic form, a manner of control logic generation used in this invention.

In the Figures like reference numerals denote like parts.

An embodiment of the invention will now be described in relation to the use of Hamming codes where bits are employed, but it is to be understood that the invention is applicable also to other more complex types of code where, instead of bits, bytes are used so that the term "bit", as used in the description of the preferred embodiment, is in a general case, synonymous with "information element", which may be data or parity.

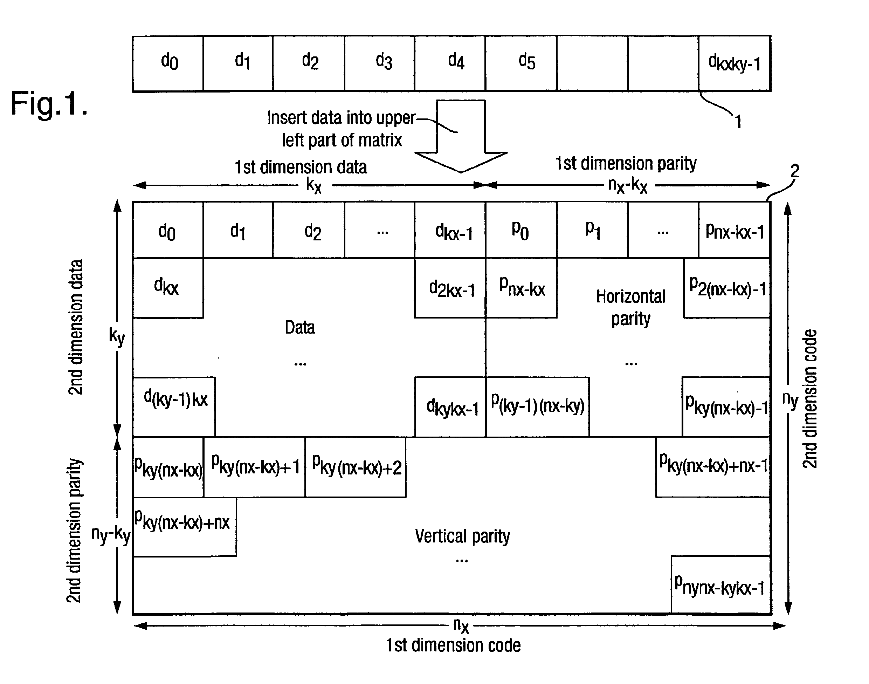

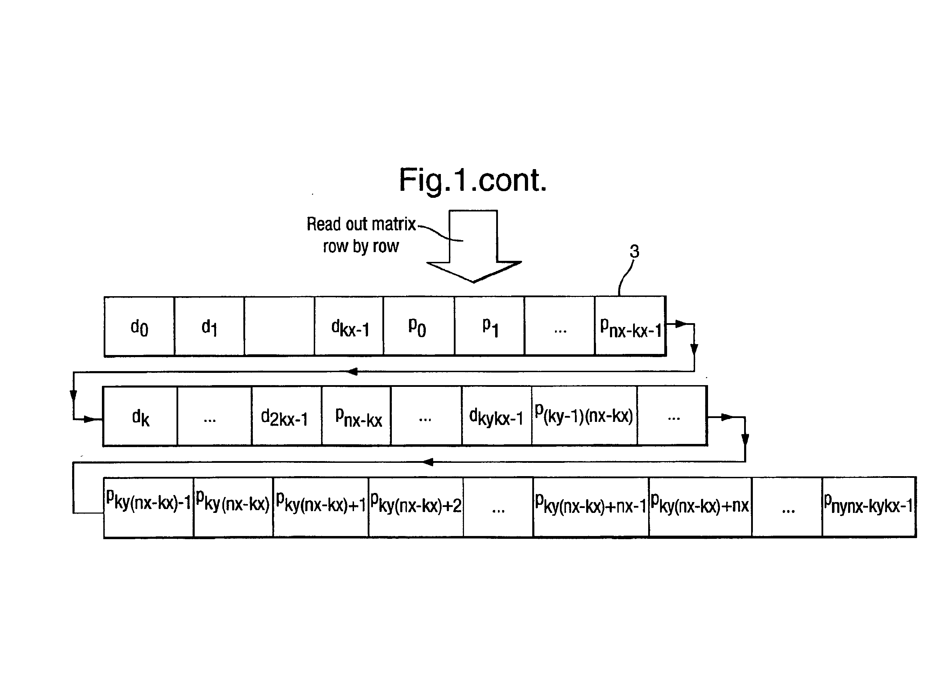

Referring to Figure 1, a data element input stream 1 comprising data bits $d_o$, $d_1$, ... $d_{kxky-1}$ is applied to an encoding matrix 2 having constituent codes $C_x$ and $C_y$. The first dimension code $C_x$ is formed by $k_x$ data bits

forming first dimension data vectors from which first dimension parity vectors are computed having $n_x$-$k_x$ parity bits. These parity bits are appended to the data bits to give an overall code length of $n_x$ bits. Similarly, the array in a second dimension has code $C_y$ formed of $k_y$ data bits forming second dimension data vectors and second dimension parity vectors formed by $n_y$-$k_y$ parity bits, and overall length $n_y$ bits. A two-dimensional array is shown in Figure 1 but it will be understood that a three-dimensional array having a third dimension code $C_z$ may be provided and such an array is intended to be within the scope of this invention.

Data is applied in horizontal rows starting from the top left corner of the array, horizontal parity vectors evaluated and data is read out from the matrix row by row, as shown by the data output 3. Thus, in a preferred embodiment, data in a first row ($d_0$ to $d_{kx}$-1) is read out followed by parity elements associated with that row ($p_0$ to $p_{nx}$-$kx$-1) before reading out data elements from the next row ($d_{kx}$ to $d_{2kx-1}$) and the parity elements associated therewith ($p_{nx}$-$kx$ to $p_{2nx-kx}$)-$_1$). The matrix is filled and sequentially read out, as shown in Figure 1, until $k_y$ first dimension code vectors have been read out, whereupon vertical parity is evaluated and read out. It will be appreciated that vertical parity for the column commencing with data bit $d_0$ may be evaluated as soon as data bit $d_{(ky-1)kx}$ has been added to the matrix. The process of evaluating vertical parity and reading out the vertical parity continues until the last parity bit $P_{nxny-kxky-1}$ is read out.

It is to be understood that for applications of the invention where the transmission channel has no memory, such as satellite links, the order in which the bits are read out is not important. However, for the purposes of designing an encoder, the memory requirement is minimised if the bits are read out in a row by row order starting with the top row.

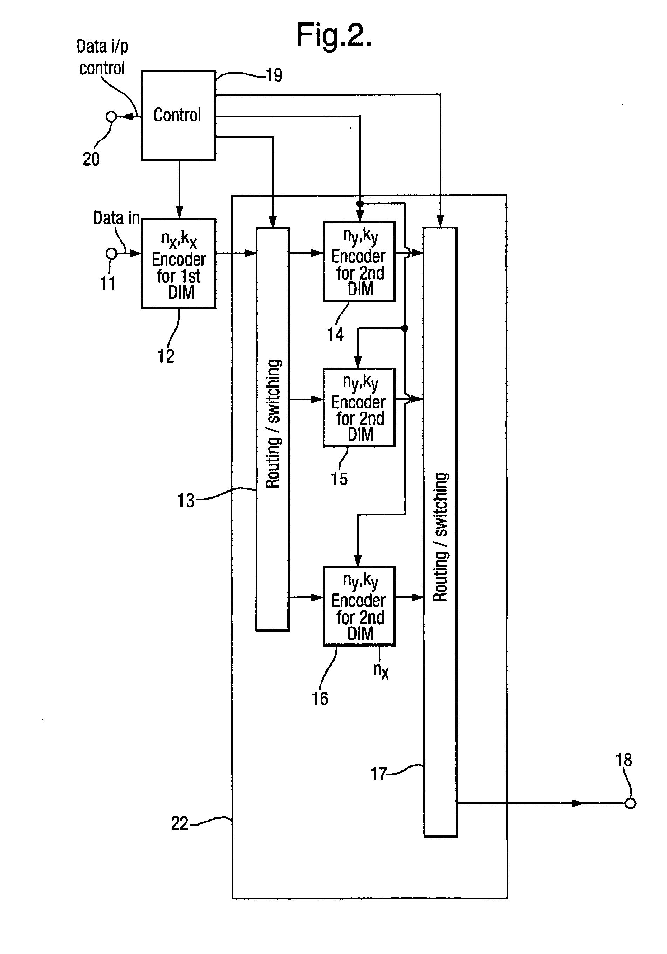

Referring to Figure 2, data at input terminal 11 is applied to an encoder 12 for a first dimension, for example, for the horizontal code $C_x$ having length $n_x$ elements. The encoder 12 may be a single extended Hamming encoder to be described in more detail hereinbelow.

Output from encoder 12 is applied to a routing/switching device 13 which does not contain memory and output from the device 13 is applied to a first encoder 14, a second encoder 15 ... $n_x$ encoder 16 for the second dimension, e.g. $n_x$ encoders for the vertical dimension code $C_y$ having bit length $n_y$. An output from each of the encoders 14-16 is applied to a further routing/switching device 17 which provides a turbo product encoded output to output terminal 18 for onward data transmission.

The encoders 12, 14-16 and devices 13, 17 are controlled by control logic 19 which also produces a control data output applied to terminal 20.

Thus, for a two-dimensional turbo product code, the architecture of the present invention comprises one encoder for a first dimension $n_x$, $k_x$, and $n_x$ en-

coders for the $n_y$, $k_y$ (second) dimension, i.e. one encoder for each column.

The overall latency for the present invention is the combined latency of both the encoder for the first dimension and the encoder for the second dimension, e.g. the encoder 12 and one of the encoders 14. An extended Hamming code may be implemented with a delay of only two clock cycles of one dimension. Thus, the overall latency of the present invention is only four clock cycles for a two-dimensional array whatever the n, k parameters for the Hamming codes that may have been chosen.

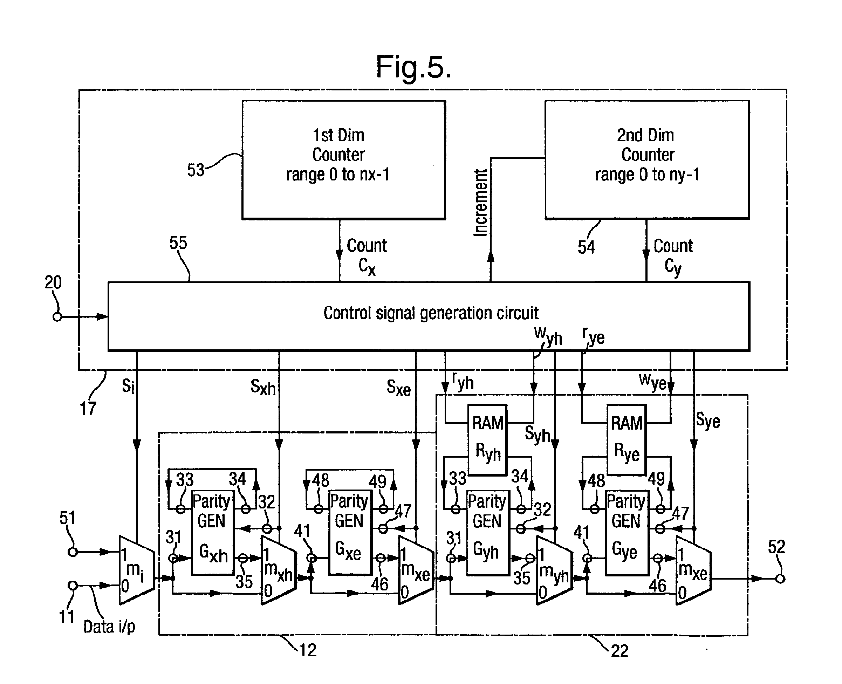

Where a turbo product code of dimensions (64, 57) by (64, 57) is required, the latency improvement over the prior art is 99.93%. Moreover, with extended Hamming codes, the present invention may be readily parameterised to allow shortening of either or both codes to an n-s, k-s code simply by changing the maximum value of the counters to be described hereinbelow with reference to Figure 5.

In the arrangement of Figure 2 it is to be understood that only a two-dimensional product code generation apparatus is shown, but a three-dimensional apparatus may be implemented by applying outputs from the device 17 to $(n_x n_y)$, $n_z$, $k_z$ encoders for a third dimension. Output from each of the encoders of the third dimension would then be applied to a further routing/switching device for output. It is to be noted that although data input may not be continuous, data output at terminal 18 may be continuous because data is read according to the data input control at terminal 20.

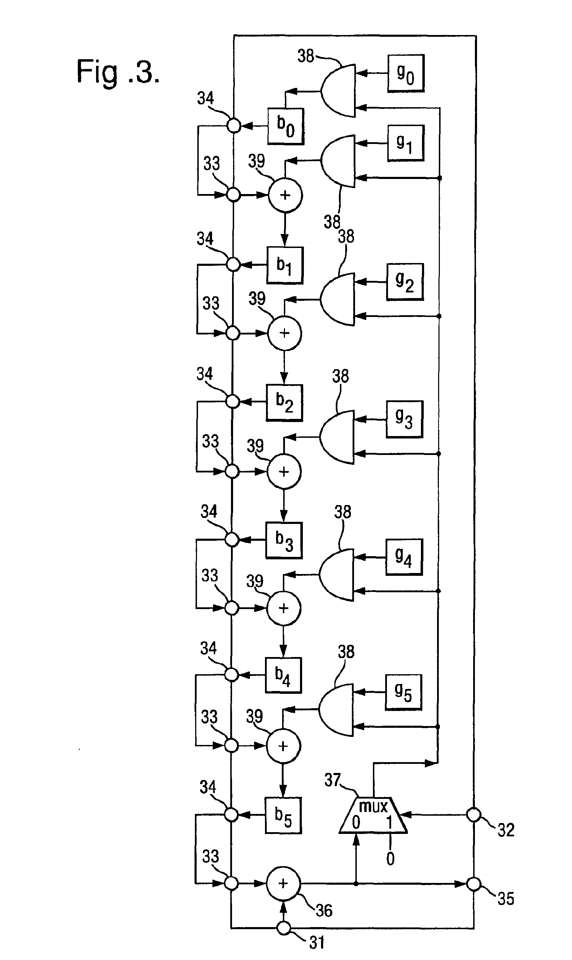

A Hamming parity code generator is shown in Figure 3 having a data input terminal 31, a gate input terminal 32, state in terminals 33, state out terminals 34 and a parity out terminal 35.

The generator shown in Figure 3 is for a Hamming code of size up to and including n=63, k=57, where the length n of the Hamming code is one less than the total number of data bits in the complete (extended Hamming) code and k is the number of data bits $k_x$ in the complete code. The generator has an input data XOR gate 36 providing parity out signals to terminal 35 and to a 0 input of a multiplexer 37, the 1 input of the multiplexer 37 being connected to signal level 0. The multiplexer 37 is controlled by signals at the gate terminal 32. An output of multiplexer 37 is passed to an input of each of six AND gates 38, the other input of each AND gate being connected to an appropriate coefficient $g_0$ to $g_5$ which represent a polynomial from which the Hamming code is constructed. Output from the AND gate 38 connected to coefficient $g_o$ is provided to a first memory element $b_o$ and the delayed output from memory element $b_o$ is provided via terminals 33, 34 to an input of an XOR gate 39 and thence to a second memory element $b_1$. The output of the AND gate associated with coefficient $g_1$ is also provided to the input of XOR gate 39. The output of the second memory element $b_1$ is applied to an associated output terminal 34, thence via an input terminal 33 to an XOR gate 39 associated with multiplier $g_2$, and so on as shown in Figure 3.

In operation, a user specifies the polynomial of the code to be generated and the bits of coefficients $g_0$-$g_5$ are set accordingly. For example, the polynomial $x_6+x+1$ would have generating bits for multipliers set as follows:

$$g_0=1, g_1=1, g_2=0, g_3=0, g_4=0, g_5=0$$

Such a polynomial is appropriate for a Hamming code n=63, k=57. For a code with fewer parity bits, e.g. n=31, k=26, a different polynomial would be used, e.g. $x^5+x+1$. In such a case, the bits of the coefficients could be generated as follows:

$$g_0=0, g_1=1, g_2=1, g_3=0, g_4=0, g_5=0$$

At start up, the memory elements $b_0$-$b_5$ have a 0 state.

The operation of the multiplexer 37 is such that when the gating signal applied at terminal 32 is 0, the multiplexer outputs the signal that is presented at its 0 input terminal. When the gating signal is 1, the multiplexer outputs the signal at its 1 input, i.e. 0.

Assuming coefficients $g_0=1$, $g_1=1$, $g_2$ ... , $g_5=0$, then with the multiplexer 37 gate input set at 0, the value of the first bit of data $d_0$ at terminal 31 is passed through multipliers associated with coefficients $g_0$ and $g_1$ so that the value of the first bit is loaded into memory elements $b_0$ and $b_1$. When the next data bit $d_1$ is applied to input terminal 31 and is passed to memory element $b_0$, memory element $b_1$ now contains data bits $d_0+d_1$, and memory element $b_2$ contains data element $d_0$. This process continues for a total of k cycles, but it will be noted that after five cycles, the state of memory element $b_5$ may be 1 or 0 and this value is XORed with the input data.

Following k cycles of data input, the gate signal of multiplexer 37 is set to 1 and the parity generator is turned into a simple shift register. Parity is read out on successive cycles when data in is set to 0. As each data bit is read out, 0's are shifted in so that the memory elements $b_0$-$b_5$ each contain 0 after the final parity bit is read.

It is to be noted that because extended Hamming codes are used, there will be one cycle for which the Hamming parity generator is idle.

If it is desired to implement a shortened code, e.g. n=62, k=56, this can be accomplished by simply clocking less data samples.

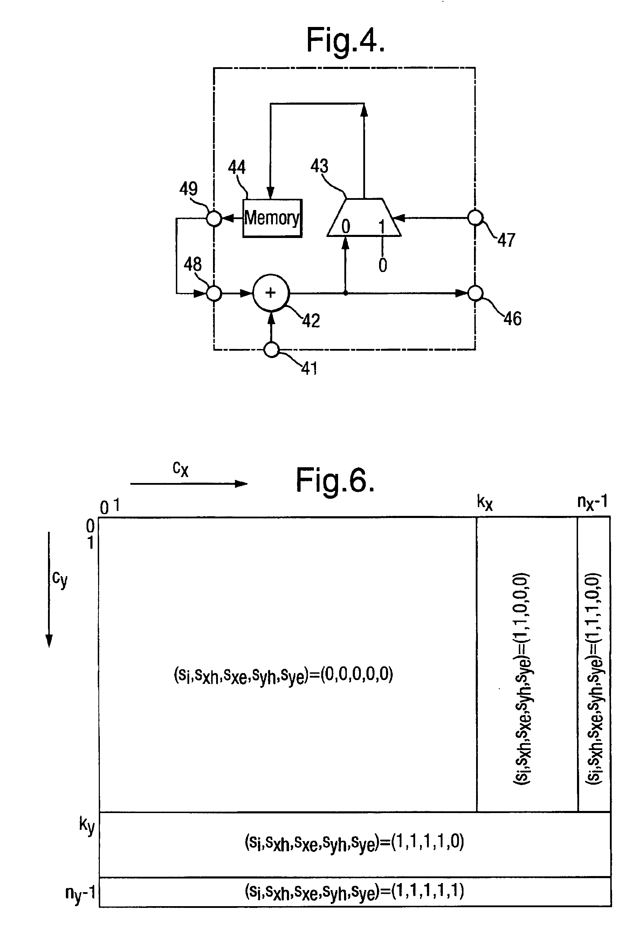

So as to generate an extended Hamming code, the sum modulo 2 of all the data and Hamming parity bits in the code word are calculated and appended as an extra parity bit. Such a circuit for generating an extended Hamming code is shown in Figure 4 in which a Hamming code comprising data and Hamming parity bits is applied to an input terminal 41. Terminal 41 is connected to an XOR gate 42. Output from gate 42 is applied to output terminal 46 and a 0 input of a multiplexer 43 having its other, 1, input connected to be supplied with a 0 level. The multiplexer 43 is controlled by a gate signal applied at terminal 47. Output from the multiplexer 43 is provided to a memory element 44 which supplies an output to another input of gate 42, via terminals 49 and 48.

Thus, the extended parity bit is calculated by the generator shown in Figure 4 having a single memory element. Starting from a memory element initial state where $b_0=0$, the generator performs an XOR function of the incoming bit with the contents of memory element 44. This is repeated for all the data bits and the Hamming parity bits, after which the multiplexer 43 is set to 1. The extended parity generator is read and cleared, ands simultaneously passes a valid extended parity bit to multiplexer $m_{xe}$ or $m_{ye}$ (described herein below) as appropriate.

A preferred embodiment of a parameterised encoder for a (64, 57) x (64, 57) two-dimensional turbo product code using extended Hamming encoders will now be described with reference to Figure 5.

In Figure 5, date input terminal 11 is connected to a 0 input of multiplexer $m_i$, the other, 1, input terminal of the multiplexer $m_i$ being connected to input terminal 51 for receiving a 0 level indicative of no data. Output from the multiplexer $m_i$ is applied to encoder 12 for the first dimension which is formed of an extended Hamming generator $G_{xh}$ having the architecture shown in Figure 3, a multiplexer $m_{xh}$, an extended Hamming generator $G_{xe}$ having the architecture shown in Figure 4 and another multiplexer $m_{xe}$. Output from multiplexer $m_i$ is applied to input terminal 31 of Hamming generator $G_{xh}$ and to the 0 input of the multiplexer $m_{xh}$, the 1 input of multiplexer $m_{xh}$ being connected to receive input from output terminal 35. Output from multiplexer $m_{xh}$ is applied to extended Hamming generator $G_{xe}$ and to the 0 input of the multiplexer $m_{xe}$, the parity output terminal 46 is applied to the 1 input terminal of multiplexer $m_{xe}$. Output from multiplexer $m_{xe}$, forming output from the first dimension encoder 12, is applied to the second dimension encoder arrangement 22 formed by the routing/switching devices 13, 17 and the second dimension encoders 14-16. The Hamming generator $G_{yh}$ for the second dimension is constructed similarly to the Hamming generator $G_{xh}$ of the first dimension and, similarly, the multiplexer $m_{yh}$ is connected to receive inputs from the multiplexer $G_{yh}$. The multiplexer $m_{xe}$ is similar to the multiplexer $m_{xh}$. Further, the extended Hamming generator $G_{ye}$ for the second dimension is similar to the extended Hamming generator $G_{xe}$ for the first dimension and multiplexer $m_{ye}$ connected to receive output from the extended Hamming generator $G_{ye}$. The multiplexer $m_{yh}$ is similar to the multiplexer $m_{xe}$. Output from the multiplexer $m_{ye}$ forms the turbo product code and is applied to output terminal 52 for use in a transmission channel.

The preferred embodiment of Figure 5, instead of requiring $n_x$ second encoders utilises random access memories (RAM) $R_{yh}$ and $R_{ye}$. RAM $R_{yh}$ is connected between state out terminal 34 and state in terminal 33. Similarly, RAM $R_{ye}$ is connected between state out terminal 49 and state in terminal 48. By using such an arrangement of RAM, the necessity for plural second dimension encoders is avoided in practice so that, in effect, the plural encoders are synthesized. The control logic 17 has a first dimension counter 53 for providing a count $c_x$ in the counter range 0 to $n_x$-1 and a second dimension counter 54 for providing a second dimension count $c_y$ in the counter range 0 to $n_y$-1. The data input control terminal 18 is connected to the counter 53 and an output of the counter 53 is connected to a control signal generation circuit 55 which provides: control signal $S_i$ to multiplexer $m_i$; control signal $S_{xh}$ to the Hamming generator multiplexer $m_{xh}$ and terminal 32; control signal $S_{xe}$ to the extended Hamming generator multiplexer $m_{xe}$ and to input terminal 47; control signal $r_{yh}$ to provide a read signal address to RAM $R_{yh}$ and a write signal address $w_{yh}$ to RAM $R_{yh}$; control signal $S_{yh}$ is applied to Hamming multiplexer $m_{yh}$ and to input terminal 32 of generator $G_{yh}$; a read address signal $r_{ye}$ is applied to RAM $R_{ye}$ and a write $w_{ye}$ address signal is applied to RAM $R_{ye}$; and a control signal $S_{ye}$ is applied to extended Hamming multiplexer $m_{ye}$ and to input terminal 47 of generator $G_{ye}$. The circuit 55 also provides an increment signal to increment the second dimension counter 54 and receives an output signal representative of $c_y$ from counter 54.

The operation of Figure 5 will now be described.

When the control signals $S_i$, $S_{xh}$, $S_{xe}$, $S_{yh}$, $S_{ye}$ are 0, the value at the data input terminal 11 is passed to the output of the respective, relevant, multiplexer $m_i$, $m_{xh}$, $m_{xe}$, $m_{yh}$, $m_{ye}$. When the control signal $S_i$, etc. is 1, the value at input terminal 51, i.e. 0, is passed to the output of the respective multipliers. When the data input control signal applied at terminal 18 is high, e.g. 1, the counter 53 increases its output count $c_x$ by 1. If this causes the count to have a value $n_x$ then the count is reset to 0. The control signal generation circuit 55 produces an enabling pulse which is generated from the counter 53 count value $c_x$ so that the counter 54 count $c_y$ is incremented as the count $c_x$ reaches the beginning of each new line and is reset to 0.

The action of each of the parity generators $G_{xh}$, $G_{xe}$, $G_{yh}$, $G_{ye}$ is as follows.

Each parity generator has five terminals, namely, input data terminal 31 or 41, output terminal 35 or 46, control data, i.e. gate, terminal 32 or 47, output state terminal 34 or 49 and input state terminal 33 or 48. When the gate terminal 32 or 47 is low, the parity generator produces an output state from the input state and the input data bit, according to the internal logic of the generator, which embodies the desired code determined by a user, e.g. a (64, 57) code or a (32, 26) code. When the gate terminal is high, parity bits are presented at the relevant parity output terminal 35 or 46. After the parity bits have been read, the output state will be all 0's so that the parity generator is ready for the start of the next code word.

Each dual port RAM $R_{yh}$, $R_{ye}$ is configured to have one read port and one write port, the respective read ports being controlled by address signals $r_{yh}$ and $r_{ye}$ and the respective write ports being controlled by address signal $w_{yh}$ and $w_{ye}$. Data is read out of RAM $R_{yh}$ or $R_{ye}$ via terminal 33 or 48 respectively in accordance with a RAM address location set by read address signal $r_{yh}$ or $r_{ye}$ respectively. Simultaneously, data from terminals 34, 49 at a data in port of RAM $R_{yh}$ and $R_{ye}$ respectively is written to a RAM memory address set by write address $w_{yh}$ or $w_{ye}$ respectively.

In the preferred embodiment, dual port RAMs are used to store the state of the parity generators in the second dimension rather than to provide a separate parity generator for every column in the two dimensional array. Therefore, by storing and fetching the states for each column the effect of an encoder for each of $n_x$ columns is synthesized, using only one Hamming parity generator and one extended parity generator. Thus, a considerable reduction in the gate count for a field programmable gate array implementation is provided.

Figure 6 shows the manner by which the control signal generation circuit 55 produces the control signals $S_i$, $S_{xh}$, $S_{xe}$, $S_{yh}$, $S_{ye}$. Thus, for the first row $c_y=0$, horizontal count signals $c_x$ from 0 to $n_x$-1 are produced before moving down the block to the second row $c_y = 1$, etc. until the last row $c_y = n_y$-1.

It will be appreciated by those skilled in the art that the values must be delayed in order to take account of increasing latency in the data path as data moves through the data path of Figure 5.

The read and write addresses are $r_{xh}$, $r_{xe}$, $w_{yh}$, $w_{ye}$ are the value of the count $c_x$ that has been delayed by an appropriate amount so that the correct value of the encoder state for any column, i.e. the second dimension, is presented at the input to the relevant parity generator at the correct moment of time, and the results of the parity calculation is stored back in the same location a short time later, thereby synthesizing the desired effect of having plural second dimension encoders.

A step-by-step operation of the embodiment shown in Figure 5 will now be described.

Encoding starts with $c_x=0$, $c_y=0$ and the contents of RAMs $R_{yh}$, $R_{ye}$ and internal states of the multiplexers and generators are set to 0.

Time step 1:

First data element $d_0$ is present at the input 11 of multiplexer $m_i$. Since $S_i=0$, the data element $d_o$ is passed to the 0 input of multiplexer $m_{xh}$ and input terminal 31 of Hamming generator $G_{xh}$.

Time step 2:

A second data element $d_1$ is present on the input 11 of multiplexer $m_i$. This is passed to the input of multiplexer $m_{hx}$ and Hamming generator $G_{xh}$. Simultaneously, the first data element is already present on the input of multiplexer $m_{xe}$ and is passed to the output of multiplexer $m_{xe}$. At the same time, the state of the Hamming generator $G_{xh}$ is updated and the state thereof is fed directly back to the input thereof.

Time step 3:

A third data element $d_2$ is present on the input of multiplexer $m_i$. This is passed to the input of multiplexer $m_{xh}$ and Hamming generator $G_{xh}$. Simultaneously, the previous element $d_1$ is present on the 0 input of multiplexer $m_{xe}$ and is passed to the output of multiplexer $m_{xe}$. At the same time, the state of the horizontal (first dimension) Hamming generator $G_{xe}$ is updated from the data element $d_1$ - the output state is fed directly back to the input of generator $G_{xh}$. Concurrently, the horizontal (first dimension) extended Hamming parity generator $G_{xe}$ operates on the data element $d_0$. Again, the state generated by generator $G_{xe}$ is fed directly back to the input of $G_{xe}$.

Time step 4:

A fourth element $d_3$ is present on the 0 input of multiplexer $m_i$. This is passed to the 0 input of the multiplexer $m_{xh}$ and on to the output of $m_{xe}$. At the same time, the state of the horizontal Hamming generator $G_{xe}$ is updated from the data element $d_2$ - the output state of generator $G_{xh}$ is fed directly back to the input of generator $G_{xh}$. Concurrently, the horizontal extended parity generator $G_{xe}$ operates on the data element $d_1$ and the vertical Hamming generator $G_{xh}$ operates on data element $d_0$.

Time step 5:

A fifth data element $d_4$ is present on the 0 input of multiplexer $m_i$. This is passed to the 0 input of multiplexer $m_{xh}$ and to the input terminal 31 of generator $G_{xh}$. At the same time, the state of the Hamming generator $G_{xh}$ is updated from the data element $d_3$ - the output state of generator $G_{xh}$ is fed directly back to the input thereof. Concurrently, the horizontal extended parity generator $G_{xe}$ operates on the data element $d_2$, the vertical Hamming parity generator $G_{yh}$ operates on data element $d_1$ and the vertical extended parity generator $G_{ye}$ operates on data element $d_0$.

Time step 6:

A sixth data element $d_5$ is present on the 0 input of multiplexer $m_i$. This is passed to the 0 input of

multiplexer $m_{xh}$ and terminal 31 of generator $G_{xh}$. Simultaneously, the previous element is already present on the 0 input of multiplexer $m_{xe}$ and is passed to the output thereof. At the same time, the state of the generator $G_{xh}$ is updated from the data element $d_4$ - the state of the generator $G_{xh}$ is fed directly back to the input thereof. Concurrently, the horizontal extended parity generator $G_{ye}$ operates on the data element $d_3$, the Hamming parity generator $G_{yh}$ operates on data element $d_2$ and the vertical extended parity generator $G_{ye}$ operates on data element $d_1$. The first element of the output word, data element $d_0$, is passed to multiplexer $m_{ye}$ and output at terminal 52.

The operation continues in similar fashion until time step $k_x$, at which point count $c_x=k_x-1$, and count $c_y=0$.

Time step $k_x+1$:

The control signal $S_i$ now has a value of 1. No data is input. Data element $d_{kx}-1$ is already present on the input of multiplexer $m_{xh}$ and is passed to the output thereof. At the same time, the state of the horizontal Hamming generator $G_{xh}$ is updated from the data element $d_{kx}$ - the output state of generator $G_{xh}$ is fed directly back to the input thereof. Concurrently, the horizontal extended parity generator $G_{xe}$ operates on the data element $d_{kx-1}$, the vertical Hamming parity generator $G_{yh}$ operates on data element $d_{kx-2}$ and the vertical extended parity generator $G_{ye}$ operates on data element $d_{kx-3}$. Data element $d_{kx-4}$ is output at terminal 52.

Time step $k_x+2$:

Having compensated for the delay introduced by $m_i$, control signal $S_{xh}$ now has the value 1. Parity element $P_0$ is present at the input of multiplexer $m_{xh}$ and the parity element is passed through to the output of multiplexer $m_{xh}$. Concurrently, the horizontal extended parity generator $G_{xe}$ operates on the data element $d_{kx}$, the vertical Hamming parity generator $G_{yh}$ operates on data element $d_{kh-1}$ and the vertical extended parity generator $G_{ye}$ operates on data element $d_{kx-2}$. Data element $d_{kh-3}$ is output at terminal 52.

The operation continues in a similar fashion until time step $n_x$, at which point $c_x=n_x-1$, $c_y=0$. Parity generator $G_{xh}$ has been cleared by the successive writing out of its contents over the preceding time steps.

Typically, 3 to 7 parity bits may predeterminedly be used.

Time step $n_x+1$:

At this time $c_x=0$, $c_y=1$. The encoder now begins processing the second row of data whilst the final bits of the first row are still being processed. Bit $d_{kx}$ is present at the input of $m_i$.

Time step $n_x(k_y-1)+k_x$:

All the data for the block has now been input.

Time step $n_h k_y+6$:

The number 6 denotes the latency of the encoder. Parity generators $G_{xh}$ and $G_{xe}$ are idle at $n_x k_y+1$. The encoder outputs vertical code (second dimension) having parity but is still calculating vertical (second dimension) extended parity. The successive clocking out of the parity causes the state of the generators $G_{xh}$, $G_{xe}$, $G_{yh}$, $G_{ye}$ to be reset, as explained above, with regard to Figures 3 and 4.

Time step $n_x(n_y-1)+6$:

The encoder outputs at terminal 52 vertical extended parity which is a product code. Each extended parity state is cleared to 0 after it is read.

Operation of the encoder may be continuous so that it begins processing the second turbo product code block as the final few bits of the first block are being output so that there is no interruption of the data stream.

For higher dimensional turbo product codes the number of encoders and routing/switching devices will increase for the same overall code length, but the latency will increase only linearly. Thus, a three-dimensional turbo product code having the same overall product length as a two-dimensional code having parameters of, say, 16, 11 by 16, 11 will have a delay of only six clock cycles, but will require 1+16+256 = 275 (16, 11) extended Hamming encoders.

It will, therefore, be seen that the latency introduced by the present invention is substantially improved over the prior art device.

## Claims

1. A method of encoding a product code having a first dimension systematic block code of length $n_x$ elements and a second dimension systematic block code of length $n_y$ elements including the steps of:

    (a) applying a data element stream to first dimension encoder means to produce said first dimension systematic block code having $k_x$ data elements and $n_x-k_x$ parity elements, where said parity elements are derived from said $k_x$ data elements,
    (b) repeatedly applying said data element stream to said first dimension encoder means to produce $k_y$ first dimension code vectors, where $k_y$ is the data element length of the second dimension systematic block code,
    (c) as each one of said $k_y$ first dimension code vectors is produced, outputting said first dimension code vectors to second dimension encoder means representative of $n_x$ encoders,

(d) deriving $(n_x n_y - n_x k_y)$ parity elements for said second dimension systematic block code vectors, and

(e) outputting second dimension code vectors as each is produced so as to provide said encoded product code.

2. A method as claimed in claim 1, wherein said product code is a turbo product code.

3. A method as claimed in claim 1 or 2, wherein said second dimension encoder means comprises $n_x$ encoders each producing a total of $n_y$ second dimension encoded elements from $k_y$ input data elements or first dimension parity elements.

4. A method as claimed in claim 3, wherein said first dimension systematic block code is applied in sequence to said second dimension encoder means and said second dimension encoder means includes a parity generator having a random access memory (RAM) associated therewith thereby repeatedly clocking data and parity elements in to an out of said RAM to synthesize said $n_x$ encoders.

5. A method as claimed in any preceding claim, wherein said systematic block code is a Hamming code.

6. A method as claimed in any of claims 1 to 4, wherein said systematic block code is an extended Hamming code.

7. A method as claimed in claim 5 or 6, wherein said data element is a single binary bit.

8. A method as claimed in claims 1 to 3, wherein said data element has a length of two or more binary digits.

9. A method as claimed in any preceding claim, wherein said first dimension encoder means includes a Hamming parity generator provided to produce said parity elements of said first dimension systematic block code.

10. A method as claimed in claim 9, wherein said first dimension encoder means also includes an extended Hamming parity generator adapted to receive output from said Hamming parity generator so as to produce an extended Hamming parity element for said first dimension systematic block code.

11. A method as claimed in any of claims 1 to 7 inclusive, wherein said second dimension encoder means includes a further Hamming parity generator connected to receive output from said extended Hamming parity generator so as to produce said parity elements of said second dimension systematic block code and, preferably, said second dimension encoder means also includes a further extended Hamming parity generator adapted to receive output from said further Hamming parity generator so as to produce said encoded product code.

12. A method as claimed in claim 11, wherein said second dimension encoder means also includes a further extended Hamming parity generator adapted to receive output from said further Hamming parity generator so as to produce said encoded product code.

13. A method as claimed in any preceding claim, wherein the output counter value of a first dimension counter having a range 0 to $n_x$-1 is applied to control signal generator means which supplies a clocking signal to a second dimension counter having a range 0 to $n_y$-1, and said control signal generator means applies control signals to said first and second dimension encoder means according to the output values of both of the aforesaid counters.

14. An apparatus for producing a product code having a first dimension systematic block code of length $n_x$ elements and a second dimension systematic block code of length $n_y$ elements, said apparatus including first dimension encoder means for receiving a data element stream to produce therefrom said first dimension systematic block code having $k_x$ data elements and $n_x$-$k_x$ parity elements, where said parity elements are derived from said $k_x$ data elements, said first dimension encoder means being arranged to produce $k_y$ first dimension code vectors, where $k_y$ is the data element length of the second dimension systematic block code, and second dimension encoder means representative of $n_x$ encoders, said second dimension encoder means being arranged to receive said first dimension code vectors as they are produced and deriving $(n_x n_y - n_x k_y)$ parity elements for said second dimension systematic block code, whereby said second encoder means is arranged to output second dimension code vectors as each is produced so as to produce said encoded product code.

15. An apparatus as claimed in claim 14, wherein said product code is a turbo product code.

16. An apparatus as claimed in claim 14 or 15, wherein said second dimension encoder means comprises $n_x$ encoders each producing a total of $n_y$ second dimension encoded elements from $k_y$ input data elements or first dimension parity elements.

17. An apparatus as claimed in claim 16, wherein said second dimension encoder means includes a parity generator having a RAM associated therewith, whereby said first dimension systematic block code is applied in sequence to said parity generator and control signal generator means are provided for repeatedly clocking data and parity elements in to and out of said RAM so that $n_x$ encoders are thereby synthesized.

18. An apparatus as claimed in claims 14 to 17 inclusive, wherein said systematic block code is a Hamming code.

19. An apparatus as claimed in claims 14 to 17 inclusive, wherein said systematic block code is an extended Hamming code.

20. An apparatus as claimed in claims 14 to 19 inclusive, wherein said data element is a single binary digit.

21. An apparatus as claimed in claims 14 to 16 inclusive, wherein said data element has a length of two or more binary digits.

22. An apparatus as claimed in any of claims 14 to 21 inclusive, wherein said first dimension encoder means includes a Hamming parity generator provided to produce said parity elements of said first dimension systematic block code.

23. An apparatus as claimed in claim 22, wherein said first dimension encoder also includes an extended Hamming parity generator adapted to receive output from said Hamming parity generator so as to produce an extended Hamming parity element for said first dimension systematic block code.

24. An apparatus as claimed in any of claims 14 to 20, wherein said second dimension encoder means includes a further Hamming parity generator connected to receive output from said extended Hamming parity generator for producing said parity elements of said second dimension systematic block code.

25. An apparatus as claimed in claim 24, wherein said second dimension encoder also includes a further extended Hamming parity generator adapted to receive output from said further Hamming generator so as to produce said encoded product code.

26. An apparatus as claimed in any of claims 14 to 25, wherein the output counter value of a first dimension counter having a range 0 to $n_x$-1 is applied to control signal generator means which supplies a clocking signal to a second dimension counter having a range 0 to $n_y$-1, and said control signal generator means applies control signals to said first and second dimension encoder means according to the output values of both of the aforesaid counters.

27. A method of encoding a turbo product code having a first dimension systematic block code of length $n_x$ elements and a second dimension systematic block code of length $n_y$ elements including the steps of:

(a) applying a data element stream to first dimension encoder means to produce said first dimension systematic block code having $k_x$ data elements and $n_x$-$k_x$ parity elements, where said parity elements are derived from said $k_x$ data elements,
(b) repeatedly applying said data element stream to said first dimension encoder means to produce $k_y$ first dimension code vectors, where $k_y$ is the data element length of the second dimension systematic block code,
(c) as each one of said $k_y$ first dimension code vectors is produced, outputting said first dimension code vectors to second dimension encoder means representative of $n_x$ encoders, said second dimension encoder means comprising $n_x$ encoders each producing a total of $n_y$ second dimension encoded elements from one of $k_y$ input data elements and first dimension parity elements,
(d) applying said first dimension systematic block code in sequence to said second dimension encoder means and said second dimension encoder means includes a parity generator having a random access memory (RAM) associated therewith thereby repeatedly clocking data and parity elements in to and out of said RAM to synthesize said $n_x$ encoders,
(e) deriving $(n_x n_y$-$n_x k_y)$ parity elements for said second dimension systematic block code vectors, and
(f) outputting second dimension code vectors as each is produced so as to provide said encoded product code.

28. An apparatus for producing a turbo product code having a first dimension systematic block code of length $n_x$ elements and a second dimension systematic block code of length $n_y$ elements, said apparatus including first dimension encoder means for receiving a data element stream to produce therefrom said first dimension systematic block code having $k_x$ data elements and $n_x$-$k_x$ parity elements, where said parity elements are derived from said $k_x$ data elements, said first dimension encoder means being arranged to produce $k_y$ first dimension code vectors, where $k_y$ is the data element length of the second dimension systematic block code, and second dimension encoder means representative of $n_x$ encoders, said second dimension encoder means

comprising $n_x$ encoders each producing a total of $n_y$ second dimension encoded elements from $k_y$ input data elements or first dimension parity elements and a parity generator having a RAM associated therewith, whereby said first dimension systematic block code is applied in sequence to said parity generator and control signal generator means are provided for repeatedly clocking data and parity elements in to and out of said RAM so that $n_x$ encoders are thereby synthesized, said second dimension encoder means being arranged to receive said first dimension code vectors as they are produced and deriving $(n_x n_y - n_x k_y)$ parity elements for said second dimension systematic block code, whereby said second encoder means is arranged to output second dimension code vectors as each is produced so as to produce said encoded product code.

Fig.1.

EP 1 225 705 A2

Fig.1.cont.

# Fig.2.

Fig .3.

# Fig.4.

# Fig.6.

$c_x$

$(s_i, s_{xh}, s_{xe}, s_{yh}, s_{ye}) = (0,0,0,0,0)$

$(s_i, s_{xh}, s_{xe}, s_{yh}, s_{ye}) = (1,1,0,0,0)$

$(s_i, s_{xh}, s_{xe}, s_{yh}, s_{ye}) = (1,1,1,0,0)$

$(s_i, s_{xh}, s_{xe}, s_{yh}, s_{ye}) = (1,1,1,1,0)$

$(s_i, s_{xh}, s_{xe}, s_{yh}, s_{ye}) = (1,1,1,1,1)$

Fig.5.